# EUROPEAN PATENT APPLICATION

(11) **EP 4 336 545 A1**
(43) Date of publication of application: **13.03.2024**
(21) Application number: 23185154.4
(22) Date of filing: 13.07.2023
(51) Int. Cl.: H01L 21/76, H01L 27/04, H01L 29/10, H01L 21/762, H01L 21/763

(54) **SEMICONDUCTOR DEVICE STRUCTURES ISOLATED BY POROUS SEMICONDUCTOR MATERIAL**

(30) Priority: 12.09.2022 US 202217942233
(71) Applicant: GlobalFoundries U.S. Inc., Malta, NY 12020 (US)
(72) Inventor: ABOU-KHALIL, Michel, Essex Junction, VT, 05452 (US); SHANK, Steven M., Essex Junction, VT, 05452 (US); MCTAGGART, Sarah, Essex Junction, VT, 05452 (US); VALLETT, Aaron, Essex Junction, VT, 05452 (US); KRISHNASAMY, Rajendran, Essex Junction, VT, 05452 (US); LYDON-NUHFER, Megan, Essex Junction, VT, 05452 (US)
(74) Representative: Lambacher, Michael

(57) **Abstract**

Semiconductor device structures with device isolation and methods of forming a semiconductor device structure with device isolation. The structure comprises a semiconductor substrate, a first semiconductor layer on the semiconductor substrate, a second semiconductor layer in a cavity in the first semiconductor layer, and a device structure including a doped region in the second semiconductor layer. The first semiconductor layer comprises a porous semiconductor material, and the second semiconductor layer comprises a single-crystal semiconductor material.

## Description

### BACKGROUND

The disclosure relates to semiconductor device fabrication and integrated circuits and, more specifically, to semiconductor device structures with device isolation and methods of forming a semiconductor device structure with device isolation.

Complementary-metal-oxide-semiconductor (CMOS) processes may be employed to build field-effect transistors that are used to construct, for example, a switch in a radio-frequency integrated circuit. A field-effect transistor generally includes a source, a drain, a semiconductor body supplying a channel region between the source and drain, and a gate electrode overlapped with the channel region. When a control voltage exceeding a characteristic threshold voltage is applied to the gate electrode, carrier flow occurs in the channel region between the source and drain to produce a device output current. Conventional field-effect transistors may exhibit an undesirably high value of off-capacitance, which may be detrimental to device performance.

Improved semiconductor device structures with device isolation and methods of forming a semiconductor device structure with device isolation are needed.

### SUMMARY

In an embodiment of the invention, a structure comprises a semiconductor substrate, a first semiconductor layer on the semiconductor substrate, a second semiconductor layer in a cavity in the first semiconductor layer, and a device structure including a doped region in the second semiconductor layer. The first semiconductor layer comprises a porous semiconductor material, and the second semiconductor layer comprises a single-crystal semiconductor material.

The first device structure may be a field-effect transistor. The first doped region may be a source or a drain of the field-effect transistor. The first device structure may further include a second doped region in the second semiconductor layer. Optionally, the first device structure may further include a gate electrode that overlaps with a portion of the second semiconductor layer positioned between the first doped region and the second doped region.

The first semiconductor layer of the structure may abut the second semiconductor layer. Additionally or alternatively, the first semiconductor layer may surround the second semiconductor layer on multiple sides. Further, the porous semiconductor material of the first semiconductor layer may be positioned between the second semiconductor layer and the semiconductor substrate.

The porous semiconductor material of the first semiconductor layer may be porous silicon. The single-crystal semiconductor material of the second semiconductor layer may be a single-crystal silicon.

The first semiconductor layer may further include a second cavity that is spaced in a lateral direction from the first cavity. The structure may further comprise a third semiconductor layer in the second cavity in the first semiconductor layer, the third semiconductor layer comprising the single-crystal semiconductor material. Optionally, the structure may further comprise a second device structure including a second doped region in the third semiconductor layer.

The porous semiconductor material of the first semiconductor layer may be positioned between the second semiconductor layer and the semiconductor substrate, and the porous semiconductor material of the first semiconductor layer may be positioned between the third semiconductor layer and the semiconductor substrate.

According to one variant, the first semiconductor layer may include a portion of the porous semiconductor material that is positioned in the lateral direction between the second semiconductor layer and the third semiconductor layer. The portion of the first semiconductor layer may abut the second semiconductor layer, and the portion of the first semiconductor layer may abut the third semiconductor layer.

According to another variant, the structure may further comprise a shallow trench isolation region in the first semiconductor layer. The shallow trench isolation region may comprise a dielectric material, and the shallow trench isolation region may be positioned in the lateral direction between the second semiconductor layer and the third semiconductor layer.

According to a further variant, the first semiconductor layer may have a first electrical resistivity, and the structure may further comprise a high-resistivity region in the first semiconductor layer, the high-resistivity region having a second electrical resistivity greater than the first electrical resistivity of the first semiconductor layer, and the high-resistivity region may be positioned in the lateral direction between the second semiconductor layer and the third semiconductor layer.

The semiconductor substrate of the structure may have a first electrical resistivity, and the first semiconductor layer may have a second electrical resistivity that is greater than the first electrical resistivity of the semiconductor substrate. Optionally, the first semiconductor layer may be thicker than the second semiconductor layer.

In an embodiment of the invention, a method comprises forming a cavity in a first semiconductor layer, forming a second semiconductor layer in the cavity in the first semiconductor layer, and forming a device structure including a doped region in the second semiconductor layer. The first semiconductor layer is positioned on a semiconductor substrate, the first semiconductor layer comprises a porous semiconductor material, and the second semiconductor layer comprises a single-crystal semiconductor material.

The second semiconductor layer in the cavity in the first semiconductor layer may be formed by epitaxially growing the second semiconductor layer inside the cavity.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIG. 1 is a cross-sectional view of a structure at an initial fabrication stages of a processing method in accordance with embodiments of the invention.
FIG. 2 is a cross-sectional view of the structure at a fabrication stage subsequent to FIG. 1.
FIG. 3 is a top view of the structure at a fabrication stage subsequent to FIG. 2.
FIG. 4 is a cross-sectional view taken generally along line 4-4 in FIG. 3.
FIG. 5 is a cross-sectional view of the structure at a fabrication stage subsequent to FIGS. 3, 4.
FIG. 6 is a cross-sectional view of a structure in accordance with alternative embodiments of the invention.
FIG. 7 is a cross-sectional view of a structure in accordance with alternative embodiments of the invention.

### DETAILED DESCRIPTION

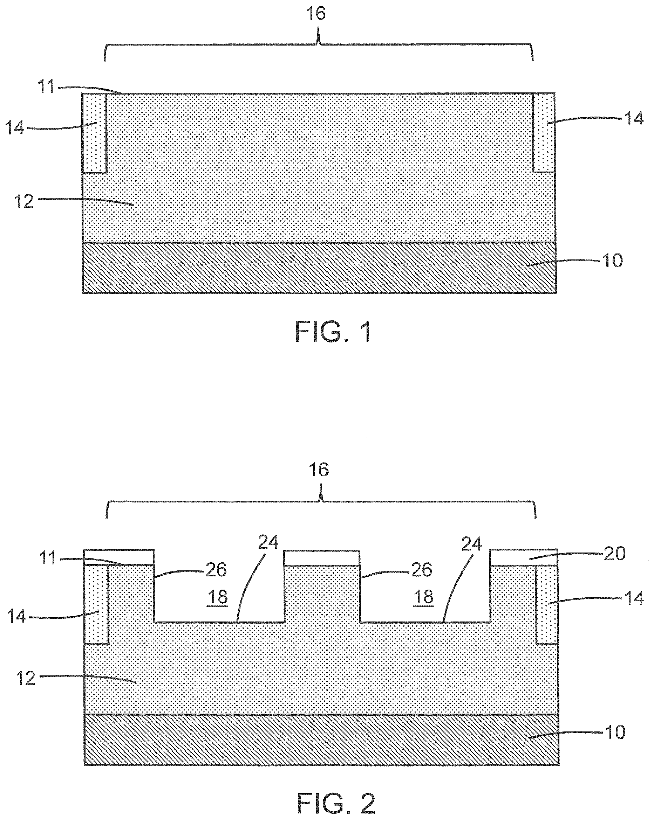

With reference to FIG. 1 and in accordance with embodiments of the invention, a semiconductor layer 12 is positioned on a semiconductor substrate 10. In an embodiment, the semiconductor substrate 10 may be comprised of a semiconductor material, such as single-crystal silicon. In an embodiment, the semiconductor layer 12 may be comprised of a porous semiconductor material. In an embodiment, the semiconductor layer 12 may be comprised of a porous semiconductor material having an electrical resistivity that is greater than the electrical resistivity of the semiconductor material of the semiconductor substrate 10. In an embodiment, the semiconductor layer 12 may be comprised of a porous semiconductor material having an electrical resistivity that is greater than 1000 ohm-cm. In an embodiment, the porous semiconductor material contained in the semiconductor layer 12 may be porous silicon. The porous semiconductor material of the semiconductor layer 12 may be formed by, for example, electrochemical anodization or chemical etching of the single-crystal semiconductor material of the semiconductor substrate 10. The porous semiconductor material includes a single-crystal matrix and interconnected pores distributed within the single-crystal matrix. The porous semiconductor material has a porosity characterized by a pore size that may range from a few nanometers to several hundreds of nanometers. The porous semiconductor material is free of crystalline grains and grain boundaries characteristic of a polycrystalline semiconductor material, such as polysilicon.

A shallow trench isolation region 14 may be formed by a shallow trench isolation technique that patterns trenches in the semiconductor layer 12 with lithography and etching processes, deposits a dielectric material to overfill the trenches, and planarizes the dielectric material using chemical mechanical polishing and/or an etch back to remove excess dielectric material. The dielectric material contained in the shallow trench isolation region 14 may be comprised of an electrical insulator, such as silicon dioxide. The shallow trench isolation region 14 fully surrounds a device region 16 of the semiconductor layer 12 in which one or more device structures may be subsequently fabricated.

With reference to FIG. 2 in which like reference numerals refer to like features in FIG. 1 and at a subsequent fabrication stage, cavities 18 are formed by lithography and etching processes in the semiconductor layer 12 and inside the boundary of the device region 16 surrounded by the shallow trench isolation region 14. To that end, a hardmask 20 may be formed on a top surface 11 of the semiconductor layer 12 and patterned to define openings at the intended locations for the cavities 18. An etching process is used to form the cavities 18 after the etch mask is formed, and the etch mask may be stripped by, for example, ashing after the cavities 18 are formed.

Each cavity 18 includes a bottom 24 and sidewalls 26 that extend from the top surface 11 to the bottom 24. A thickness of the porous semiconductor material of the semiconductor layer 12 is positioned in a vertical direction between the bottom 24 of each cavity 18 and the semiconductor substrate 10. A portion of the porous semiconductor material of the semiconductor layer 12 is positioned in a lateral direction between each cavity 18 and the shallow trench isolation region 14. The porous semiconductor material of the semiconductor layer 12 includes a portion that is positioned in a lateral direction between the cavities 18.

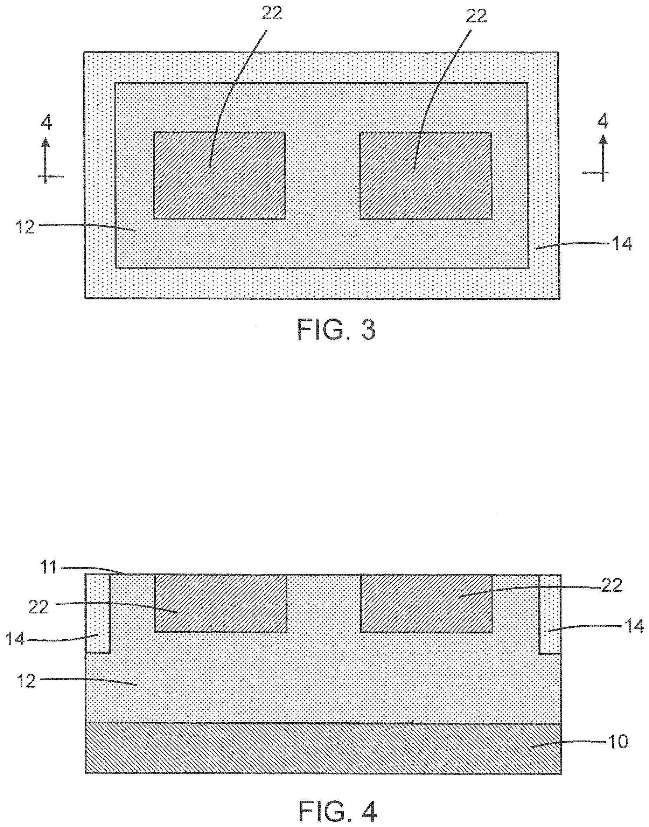

With reference to FIGS. 3, 4 in which like reference numerals refer to like features in FIG. 2 and at a subsequent fabrication stage, a semiconductor layer 22 may be formed inside each cavity 18 with the hardmask 20 (FIG. 2) present on the top surface of the semiconductor layer 12. The semiconductor layers 22, which adopt the shape and dimensions of the cavities 18, may be formed by an epitaxial growth process. The semiconductor layers 22 may be comprised of single-crystal semiconductor material (e.g., single-crystal silicon) that is free of crystalline grains and grain boundaries. The porous semiconductor material of the semiconductor layer 12 at the bottom 24 and sidewalls 26 of each cavity 18 (FIG. 2) serves as a crystalline template for the epitaxial growth of the semiconductor layers 22. The semiconductor layers 22 may be doped during epitaxial growth with a concentration of a dopant, such as an n-type dopant (e.g., arsenic) to provide n-type conductivity. In an embodiment, the semiconductor layer 12 may be thicker than the semiconductor layers 22. The hardmask 20 may be removed after forming the semiconductor layers 22.

Each semiconductor layer 22 is surrounded on multiple sides by the porous semiconductor material of the semiconductor layer 12. Each semiconductor layer 22 may abut and directly contact the semiconductor layer 12. The porous semiconductor material of the semiconductor layer 12 is positioned in a vertical direction between each semiconductor layer 22 and the semiconductor substrate 10. The porous semiconductor material of the semiconductor layer 12 includes a portion that is positioned in a lateral direction between each semiconductor layer 22 and the shallow trench isolation region 14. A portion of the porous semiconductor material of the semiconductor layer 12 is positioned in a lateral direction between the different semiconductor layers 22.

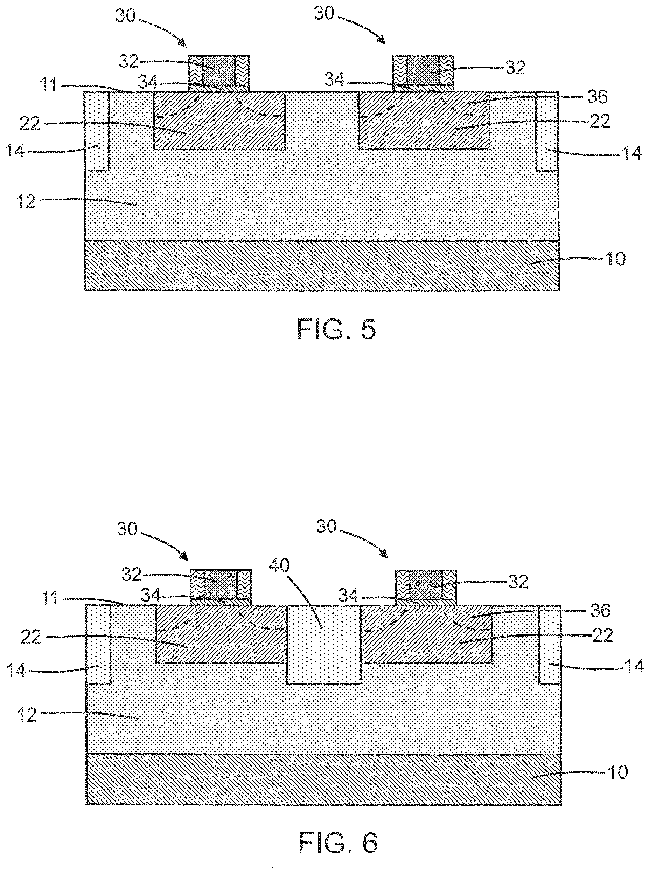

With reference to FIG. 5 in which like reference numerals refer to like features in FIGS. 3, 4 and at a subsequent fabrication stage, field-effect transistors 30 may be formed as representative device structures in the semiconductor layers 22. In the representative embodiment, one of the field-effect transistors 30 may be formed in each semiconductor layer 22. Each field-effect transistor 30 may include a gate electrode 32 and a gate dielectric layer 34 formed on the surface of the semiconductor layer 22 by depositing a layer stack and patterning the layer stack with photolithography and etching processes. The gate electrode 32 may be comprised of a conductor, such as doped polycrystalline silicon (i.e., polysilicon) or a work function metal, and the gate dielectric layer 34 may be comprised of an electrical insulator, such as silicon dioxide or hafnium oxide. Each field-effect transistor 30 may include source/drain regions 36 positioned in the semiconductor layer 22. The source/drain regions 36 represent doped regions containing a concentration of a dopant, such as an n-type dopant (e.g., arsenic or phosphorus) that provides n-type conductivity. Alternatively, the source/drain regions 36 may be doped with a concentration of a p-type dopant (e.g., boron) that provides p-type conductivity. As used herein, the term "source/drain region" means a doped region of semiconductor material that can function as either a source or a drain of a field-effect transistor. Each gate electrode 32 overlaps with a portion of the corresponding semiconductor layer 22 positioned between the different source/drain regions 36.

The field-effect transistors 30 are not formed in the porous semiconductor material of the semiconductor layer 12. Instead, the field-effect transistors 30 are formed in the single-crystal semiconductor material of the semiconductor layers 22, each of which is surrounded on multiple sides by the porous semiconductor material of the semiconductor layer 12. In an alternative embodiment, one or both of the field-effect transistors 30 may include multiple gate electrodes 32 and source/drain regions 36 that are arranged relative to the multiple gate electrodes 32 to define a switch field-effect transistor, which may be deployed in a radio-frequency front-end integrated circuit.

In an embodiment, the field-effect transistors 30 may be constructed as device structures of the same type. In an alternative embodiment, the field-effect transistors 30 may be replaced by another type of device structure that includes one or more doped regions formed in the semiconductor layers 22. In an alternative embodiment, the field-effect transistors 30 may be constructed as different types of transistors, such as a logic field-effect transistor and a switch field-effect transistor.

Performance metrics characterizing the field-effect transistors 30, which are formed in the single-crystal semiconductor material of the semiconductor layers 22, may be improved because of the porous semiconductor material of the semiconductor layer 12 that is arranged between the field-effect transistors 30 and the semiconductor substrate 10. For example, the porous semiconductor material of the semiconductor layer 12 may operate to reduce the off-capacitance of the field-effect transistors 30.

With reference to FIG. 6 and in accordance with alternative embodiments of the invention, a trench isolation region 40 may be positioned in the semiconductor layer 12 at a location between the different semiconductor layers 22. The trench isolation region 40 may be comprised of a dielectric material, such as silicon dioxide, that is located inside a trench patterned by lithography and etching processes in the semiconductor layer 12. In an embodiment, the trench isolation region 40 may abut and directly contact each of the semiconductor layers 22. In an embodiment, the trench isolation region 40 and the shallow trench isolation region 14 may be concurrently formed.

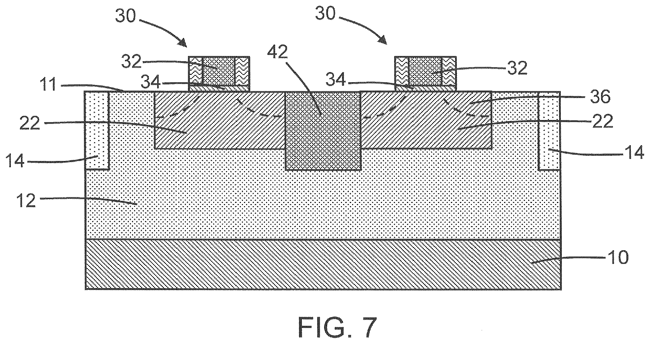

With reference to FIG. 7 and in accordance with alternative embodiments of the invention, a high-resistivity region 42 may be formed in the semiconductor layer 12 at a location between the different semiconductor layers 22. In an embodiment, the high-resistivity region 42 may abut and directly contact each of the semiconductor layers 22. The electrical resistivity of the high-resistivity region 42 may be greater than the electrical resistivity of the semiconductor layer 12. In an embodiment, the high-resistivity region 42 may be comprised of a polycrystalline semiconductor material, such as polysilicon, formed in the semiconductor layer 12 by a masked ion implantation and a subsequent anneal that recrystallizes the implantation-damaged semiconductor material.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features may "overlap" if a feature extends over, and covers a part of, another feature with either direct contact or indirect contact.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor substrate;
a first semiconductor layer on the semiconductor substrate, the first semiconductor layer comprising a porous semiconductor material, and the first semiconductor layer including a first cavity;
a second semiconductor layer in the first cavity in the first semiconductor layer, the second semiconductor layer comprising a single-crystal semiconductor material; and
a first device structure including a first doped region in the second semiconductor layer.

2. The structure of claim 1 wherein the first device structure is a field-effect transistor, and the first doped region is a source or a drain of the field-effect transistor.

3. The structure of claim 1 or claim 2 wherein the first semiconductor layer abuts the second semiconductor layer, and/or wherein the first semiconductor layer surrounds the second semiconductor layer on multiple sides.

4. The structure of one of claims 1 to 3 wherein the porous semiconductor material of the first semiconductor layer is positioned between the second semiconductor layer and the semiconductor substrate.

5. The structure of one of claims 1 to 4 wherein the porous semiconductor material is porous silicon, and the single-crystal semiconductor material of the second semiconductor layer is single-crystal silicon.

6. The structure of one of claims 1 to 5 wherein the first semiconductor layer includes a second cavity that is spaced in a lateral direction from the first cavity, and further comprising:
a third semiconductor layer in the second cavity in the first semiconductor layer, the third semiconductor layer comprising the single-crystal semiconductor material, and, optionally, a second device structure including a second doped region in the third semiconductor layer.

7. The structure of claim 6 wherein the first semiconductor layer includes a portion of the porous semiconductor material that is positioned in the lateral direction between the second semiconductor layer and the third semiconductor layer.

8. The structure of claim 7 wherein the portion of the first semiconductor layer abuts the second semiconductor layer, and the portion of the first semiconductor layer abuts the third semiconductor layer.

9. The structure of one of claims 6 to 8 wherein the porous semiconductor material of the first semiconductor layer is positioned between the second semiconductor layer and the semiconductor substrate, and the porous semiconductor material of the first semiconductor layer is positioned between the third semiconductor layer and the semiconductor substrate.

10. The structure of claim 6 further comprising:
a shallow trench isolation region in the first semiconductor layer, the shallow trench isolation region comprising a dielectric material, and the shallow trench isolation region positioned in the lateral direction between the second semiconductor layer and the third semiconductor layer.

11. The structure of claim 6 wherein the first semiconductor layer has a first electrical resistivity, and further comprising:
a high-resistivity region in the first semiconductor layer, the high-resistivity region having a second electrical resistivity greater than the first electrical resistivity of the first semiconductor layer, and the high-resistivity region positioned in the lateral direction between the second semiconductor layer and the third semiconductor layer.

12. The structure of one of claims 1 to 11 wherein the semiconductor substrate has a first electrical resistivity, and the first semiconductor layer has a second electrical resistivity that is greater than the first electrical resistivity of the semiconductor substrate, and, optionally, wherein the first semiconductor layer is thicker than the second semiconductor layer.

13. The structure of one of claims 1 to 12 wherein the first device structure including a second doped region in the second semiconductor layer, and, optionally, wherein the first device structure includes a gate electrode that overlaps with a portion of the second semiconductor layer positioned between the first doped region and the second doped region.

14. A method comprising:
forming a cavity in a first semiconductor layer, wherein the first semiconductor layer is positioned on a semiconductor substrate, and the first semiconductor layer comprises a porous semiconductor material;
forming a second semiconductor layer in the cavity in the first semiconductor layer, wherein the second semiconductor layer comprises a single-crystal semiconductor material; and
forming a device structure including a doped region in the second semiconductor layer.

15. The method of claim 14 wherein forming the second semiconductor layer in the cavity in the first semiconductor layer comprises:
epitaxially growing the second semiconductor layer inside the cavity.
